# EUROPEAN PATENT APPLICATION

(11) **EP 2 302 875 A1**
(43) Date of publication of application: **30.03.2011**
(21) Application number: 09797774.8
(22) Date of filing: 12.06.2009
(51) Int. Cl.: H04M 1/00, G01R 31/36, H01M 10/42, H02J 7/00

(54) **PORTABLE DEVICE, DISPLAY METHOD, AND DISPLAY PROGRAM**

(30) Priority: 15.07.2008 JP 2008184228
(71) Applicant: Mitsumi Electric Co., Ltd., Tama-shi Tokyo 206-8567 (JP)
(72) Inventor: ASAI, Takanori, Tama-Shi Tokyo 206-8567 (JP)
(74) Representative: Maiwald Patentanwalts GmbH
(86) International application number: PCT/JP2009/060745
(87) International publication number: WO 2010/007846

(57) **Abstract**

A portable device driven by a battery unit including a rechargeable battery which can be charged and discharged, the portable device includes an impact detecting part configured to detect an impact applied to the portable device; an abnormality determining part configured to determine whether an abnormality is generated in the battery unit based on status information indicating the status of the battery unit; and a display control part configured to control displaying by a displaying device of the portable device, wherein the abnormality determining part determines whether the abnormality is generated in the battery unit in a case where the impact is detected by the impact detecting part; and the display control part performs the displaying indicating the abnormality of the battery unit in a case where the abnormality determining part determines that the battery unit is abnormal.

## Description

### TECHNICAL FIELD

The present invention generally relates to portable devices, display methods, and display programs. More specifically, the present invention generally relates to a portable device driven by a battery unit including a rechargeable battery which can be charged or discharged, a display method by the portable device, and a display program.

### BACKGROUND ART

Recently, portable devices, driven by a battery unit including a rechargeable battery, such as a lithium-ion battery, are in the course of being spread. It is a normal practice that a monitoring IC or the like configured to monitor a state of the battery unit provided in the portable device is provided in the portable device so that safety in use of the portable device is secured. If an abnormality is generated in the battery unit, the abnormality can be detected by the monitoring IC or the like. A portable phone configured to detect an abnormality of the battery and report it is discussed in, for example, Patent Document 1.
[Patent Document 1] Japanese Patent Application Publication No. 2000-78250

### DISCLOSURE OF THE INVENTION

### PROBLEMS TO BE SOLVED BY THE INVENTION

However, according to the above-discussed related art, only battery abnormalities due to degradation or the like of the battery are detected. Therefore, the status of a portable device main body is not connected to a timing of detection of the battery abnormality. Therefore, in a case where an impact or the like is provided to the portable device due to some reason so that the abnormality of the battery is generated due to this impact, the battery abnormality may not be immediately detected so that the battery having a problem may be continuously used.

### MEANS FOR SOLVING PROBLEMS

Accordingly, embodiments of the present invention may provide a novel and useful portable device, display method, and display program solving one or more of the problems discussed above.

More specifically, the embodiments of the present invention may provide a portable device configured to immediately detect the battery abnormality when the impact is applied to the portable device main body so as to report the battery abnormality, a display method, and a display program.

One aspect of the present invention may be to provide a portable device driven by a battery unit including a rechargeable battery which can be charged and discharged, the portable device including an impact detecting part configured to detect an impact applied to the portable device; an abnormality determining part configured to determine whether an abnormality is generated in the battery unit based on status information indicating the status of the battery unit; and a display control part configured to control displaying by a displaying device of the portable device, wherein the abnormality determining part determines whether the abnormality is generated in the battery unit in a case where the impact is detected by the impact detecting part; and the display control part performs the displaying indicating the abnormality of the battery unit in a case where the abnormality determining part determines that the battery unit is abnormal.

The portable device may further include a monitoring part configured to monitor the status of the battery unit and obtain the status information of the battery unit, wherein the abnormality determining part refers to the status information obtained by the monitoring part so as to determine whether the abnormality is generated in the battery unit.

The monitoring part may include an electric current detecting part configured to detect an electric current flowing in the battery unit; a voltage detecting part configured to detect a voltage of the battery unit; a temperature detecting part configured to detect a temperature of the battery unit; and an internal short circuit detecting part configured to detect an internal short circuit of the battery unit.

The battery unit and the monitoring part may be included in a battery pack provided in the portable device.

Another aspect of the present invention may be to provide a display method of a portable device, the portable device being driven by a battery unit including a rechargeable battery which can be charged and discharged, the display method including an impact detecting step of detecting an impact applied to the portable device; an abnormality determining step of determining whether an abnormality is generated in the battery unit based on status information indicating the status of the battery unit; and a display control step of controlling displaying by a displaying device of the portable device, wherein, in the abnormality determining step, whether the abnormality is generated in the battery unit is determined in a case where the impact is detected in the impact detecting step; and the displaying indicating the abnormality of the battery unit is performed in the display control step in a case where it is determined that the battery unit is abnormal in the abnormality determining step.

Other aspect of the present invention may be to provide a display program performed in a portable device, the portable device being driven by a battery unit including a rechargeable battery which can be charged and discharged, the program making the portable device execute a method, the method including an impact detecting step of detecting an impact applied to the portable device; an abnormality determining step of determining whether an abnormality is generated in the battery unit based on status information indicating the status of the battery unit; and a display control step of controlling displaying by a displaying device of the portable device, wherein, in the abnormality determining step, whether the abnormality is generated in the battery unit is determined in a case where the impact is detected in the impact detecting step; and the displaying indicating the abnormality of the battery unit is performed in the display control step in a case where it is determined that the battery unit is abnormal in the abnormality determining step.

Other objects, features, and advantages of the present invention will become more apparent from the following detailed description when read in conjunction with the accompanying drawings.

### EFFECT OF THE INVENTION

According to the embodiment of the present invention, it is possible to immediately detect the battery abnormality when the impact is applied to the portable device main body so as to report the battery abnormality.

### BRIEF DESCRIPTION OF DRAWINGS

FIG. 1 is a view showing an example of a hardware structure of a portable device 100 of the present invention;
FIG. 2 is a view for explaining a functional structure of the portable device 100 of the present invention;
FIG. 3 is a view for explaining a battery pack 200 provided in the portable device 100;
FIG. 4 is a view showing an example of a hardware structure of a monitoring IC 220;
FIG. 5 is a view for explaining a functional structure of the monitoring IC 220;
FIG. 6 is a flowchart for explaining operations of the portable device 100 of the present invention;
FIG. 7 is a view showing a first example of a screen displayed by a displaying device 12 of the portable device 100;
FIG. 8 is a view showing a second example of a screen displayed by a displaying device 12 of the portable device 100; and
FIG. 9 is a view showing a third example of a screen displayed by a displaying device 12 of the portable device 100.

### BEST MODE FOR CARRYING OUT THE INVENTION

In the present invention, when an impact applied to a portable device main body is detected, information indicating a status of the battery unit is referred to. Whether an abnormality is generated in the battery unit is detected by this information. In a case where the abnormality of the battery unit is detected, a message or the like indicating the abnormality is displayed by a displaying device so that the battery abnormality is immediately detected and the battery abnormality is reported.

### [Embodiments]

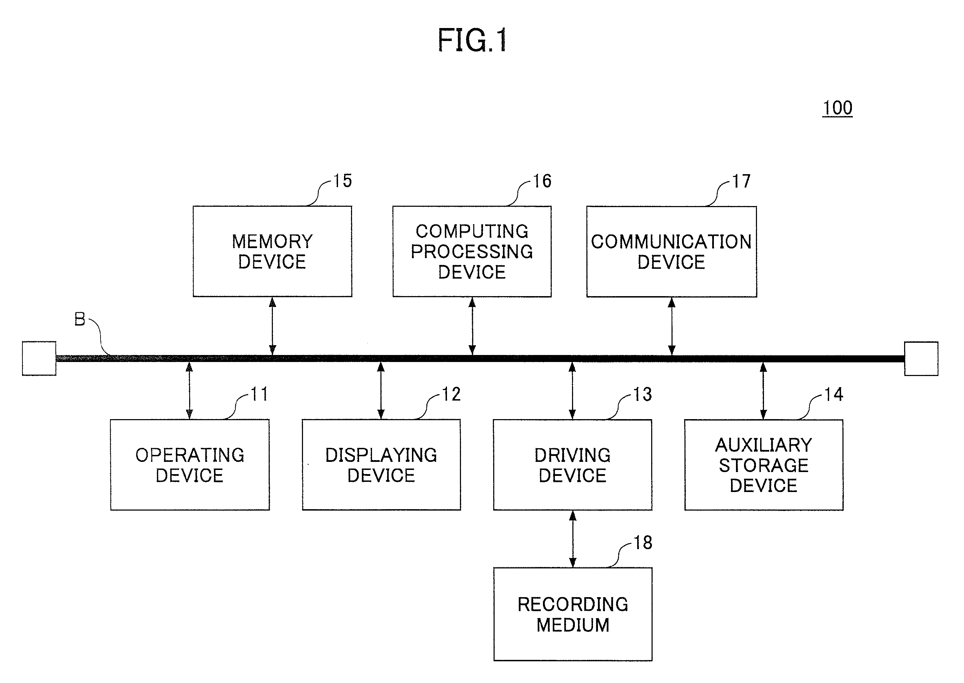

A description is given below, with reference to FIG. 1 through FIG. 9, of embodiments of the present invention. FIG. 1 is a view showing an example of a hardware structure of a portable device 100 of the embodiments of the present invention.

The portable device 100 includes an operating device 11, a displaying device 12, a drive device 13, an auxiliary storage device 14, a memory device 15, a computing processing device 16, and a communication device 17 connected to each other via a bus B.

The operating device 11 is configured to operate the portable device 100. Various kinds of signals are input so that the portable device 100 is operated. More specifically, the operating device 11 has operations buttons or the like such as an electric power key or ten keys. The displaying device 12 is, for example, a liquid crystal display or the like. A guide screen whereby operations of the portable device 100 are guided, a progress status of a process implemented by the portable device 100, or the like is displayed on the displaying device 12. By the communication device 17, the portable device 100 can communicate with other portable devices, base stations, or the like. More specifically, the communication device 17 performs a process or the like for transmitting or receiving data from, for example, an antenna provided at the portable device 100.

The display program of the embodiments of the present invention is at least a part of various programs whereby the portable device 100 is controlled. The display program is provided by, for example, distribution of a recording medium 18 where the display program is stored or receipt of the display program via the communication device 17. The recording medium 18, such as a memory card, where the display program is recorded is readable by the portable device 100.

In addition, if the recording medium 18 where the display program is recorded is set in the drive device 13, the display program is installed from the recording medium 18 into the auxiliary storage device 14 via the drive device 13. The display program received by the communication device 17 is installed into the auxiliary storage device 14.

In addition to the installed display program, necessary files, data or the like are stored in the auxiliary storage device 14. The memory device 15 reads out and loads the display program from the auxiliary storage device 14 at the time of starting the portable device 100. In addition, the computing process device 16 realizes various kinds of processes discussed below by using the display program loaded in the memory device 15.

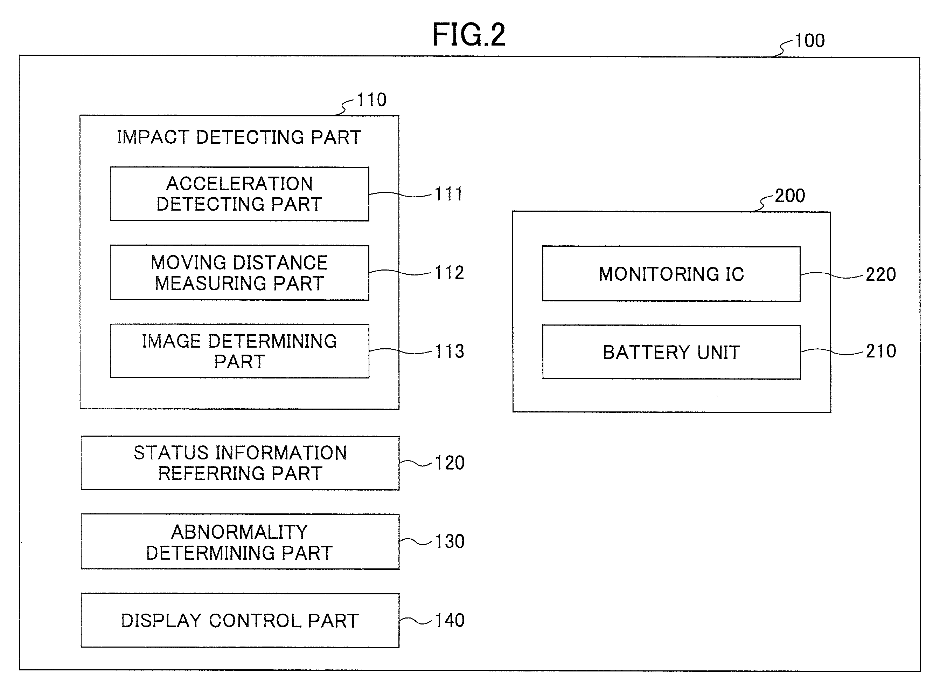

Next, a functional structure of the portable device 100 of the embodiment is discussed with reference to FIG. 2. FIG. 2 is a view for explaining the functional structure of the portable device 100 of the present invention.

A battery pack 200 is mounted in the portable device 100 of the embodiment. Electric power is supplied from a battery unit 210 of the battery pack 200 so that the portable device 100 is operated. Details of the battery pack 200 are discussed below.

The portable device 100 of the embodiment includes an impact detecting part 110, a status information referring part 120, an abnormality determining part 130, and a display control part 140. In the portable device 100, when the impact is detected by the impact detecting part 110, status information of the battery unit 210 obtained by a monitoring IC 220 in the battery pack 200 is referred to by the status information referring part 120. In addition, the abnormality determining part 130 determines whether an abnormality is generated in the battery unit 210 based on the received information status. In a case where it is determined that an abnormality is generated, the display control part 140 makes the displaying device 12 display information about the generation of the abnormality.

Details of a function of each of parts of the portable device 100 are discussed next.

The impact detecting part 110 of the embodiment includes an acceleration detecting part 111, a moving distance measuring part 112, and an image determining part 113.

The acceleration detecting part 111 is configured to detect acceleration, for example, when the portable device 100 moves. In addition, the acceleration detecting part 111 is configured to detect impacts applied to the portable device 100, for example, when the portable device 100 falls. The acceleration detecting part 111 of the embodiment determines that an impact is applied to the portable device 100 in a case where a detected acceleration is equal to or greater than a designated value or in a case where impact is detected when the portable device 100 falls.

The moving distance measuring part 112 is configured to measure a moving distance and a moving time of the portable device 100 by, for example, a GPS (Global Positioning System) function and others provided in the portable device 100. The acceleration detecting part 111 of the embodiment determines that an impact is applied to the portable device 100, for example, in a case where the moving distance at the designated moving time of the portable device 100 measured by the moving distance measuring part 112 is equal to or greater than a designated value.

The image determining part 113 is configured to make an imaging means such as a camera provided in the portable device 100 always work so that images are taken, and to measure the moving distance of the portable device 100 based on the taken images. The impact detecting part 110 of the embodiment determines that an impact is applied to the portable device 100, for example, in a case where it is determined by the image determining part 113 that the images taken show movement of a distance equal to or greater than a designated distance for a time equal to or greater than a designated time.

The impact detecting part 110 of the embodiment may detect the impact applied to the portable device 100 by using any of the above-mentioned acceleration detecting part 111, moving distance measuring part 112, and image determining part 113. In this case, it may be determined that the impact is applied to the portable device 100 when the impact is detected by all of the above-mentioned acceleration detecting part 111, moving distance measuring part 112, and image determining part 113. It may be determined that the impact is applied to the portable device 100 when the impact is detected by one of the above-mentioned acceleration detecting part 111, moving distance measuring part 112, and image determining part 113.

The impact detecting part 110 of the embodiment may include one or two among the acceleration detecting part 111, the moving distance measuring part 112, and the image determining part 113. The impact detecting part 110 of the embodiment may detect that the impact is applied to the portable device 100.

The status information referring part 120 is configured to refer to status information of the battery unit 210 obtained by the monitoring IC 220 of the battery pack 200. The status information in this embodiment is, for example, information indicating a voltage of the battery unit 210, information indicating an electric current of the battery unit 210, information indicating a resistance value of the battery unit 210, information indicating a temperature of the battery unit 210, information indicating whether an internal short circuit of the battery unit 210 is detected, or the like. Details of obtaining of the status information of the battery unit 210 by the monitoring IC 220 are discussed below.

The abnormality determining part 130 is configured to determine whether an abnormality is generated in the battery unit 210 based on the status information referred to by the status information referring part 120.

More specifically, the abnormality determining part 130 determines that the abnormality is generated in the battery unit 210 in a case where, for example, the voltage, the electric current, the resistance value, or the temperature of the battery unit 210 included in the referred to status information is out of the designated range having been set in advance. In addition, the abnormality determining part 130 determines that the abnormality is generated in a case where the internal short circuit of the battery unit 210 is detected.

The display control part 140 is configured to control displaying by the displaying device 12. The display control part 140 of this embodiment makes the displaying device 12 display a message indicating generation of the abnormality, a message encouraging exchange of the battery pack 200, or the like, for example, when the abnormality determining part 130 determines that the abnormality is generated.

Here, before operations of the portable device 100 of this embodiment are discussed, the battery pack 200 provided in the portable device 100 is discussed.

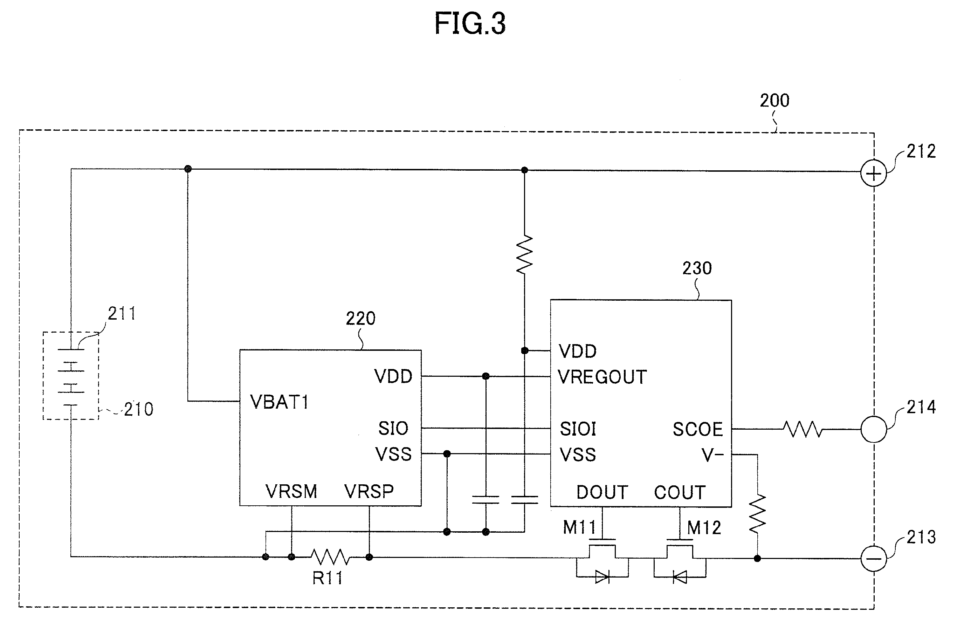

FIG. 3 is a view for explaining the battery pack 200 provided in the portable device 100. The battery pack 200 includes the battery unit 210 where plural rechargeable batteries (secondary batteries) 211, such as lithium-ion batteries, are connected. Although the rechargeable batteries 211 are connected in series to the battery unit 210 in this embodiment, the present invention is not limited to this structure.

The battery pack 200 includes the monitoring IC 220, and a protecting IC 230 provided between a cathode terminal 212 and an anode terminal 213 and the battery unit 210. The cathode terminal 212 and the anode terminal 213 are configured to connect the portable device 100 where the battery pack 200 is provided.

The monitoring IC 220 is configured to monitor the status of the battery unit 210 and obtain the status information of the battery unit 210. In addition, when receiving the referred to information of the status information from the portable device 100, the monitoring IC 220 provides the obtained status information to the portable device 100.

The monitoring IC 220 includes an electric power source terminal VDD, a standard electric potential terminal VSS, a voltage detecting terminal VBAT1, a pair of electric current detecting terminals VRSP and VRSM, and a communication terminal SIO. The monitoring IC 220 receives, via the electric power source terminal VDD, a voltage regulated from the battery voltage at the protecting IC 230. The standard electric potential terminal VSS is connected to an anode of the battery unit 210.

The monitoring IC 220 can detect an output voltage of the battery unit 210 via the voltage detecting terminal VBAT1 connected to the cathode of the battery unit 210. The electric current detecting terminal VRSM is connected to the anode of the rechargeable battery 211 and connected to the electric current detecting terminal VRSP via a resistor R11 at an outside of the monitoring IC 220.

The monitoring IC 220 is configured to detect charge or discharge electric current, namely an electric current flowing through the external resistor R11 via the electric current detecting terminals VRSP and VRSM. In addition, the monitoring IC 220 of this embodiment is configured to detect an internal short circuit of the battery unit 210. The communication terminal SIO is connected to an external connection 214 used for communicating with the portable device 100. The monitoring IC 220 of this embodiment is configured to communicate with the portable device 100 via the communication terminal SIO and the protecting IC 230. Details of the monitoring IC 220 are discussed below.

The protecting IC 230 is configured to protect the battery pack 200 from excessive charge and excessive discharge. The protecting IC 230 includes terminals DOUT and COUT connected to gates of MOS transistors M11 and M22 configured to block charge and discharge of the battery pack 200. When the excessive discharge or an excessive electrical current is detected, the protecting IC 230 blocks the MOS transistor M11 by making the DOUT output be at a low level. When the excessive charge is detected by an excessive charge detecting circuit, the protecting IC 230 blocks the MOS transistor M12 by making the COUT output be at a low level.

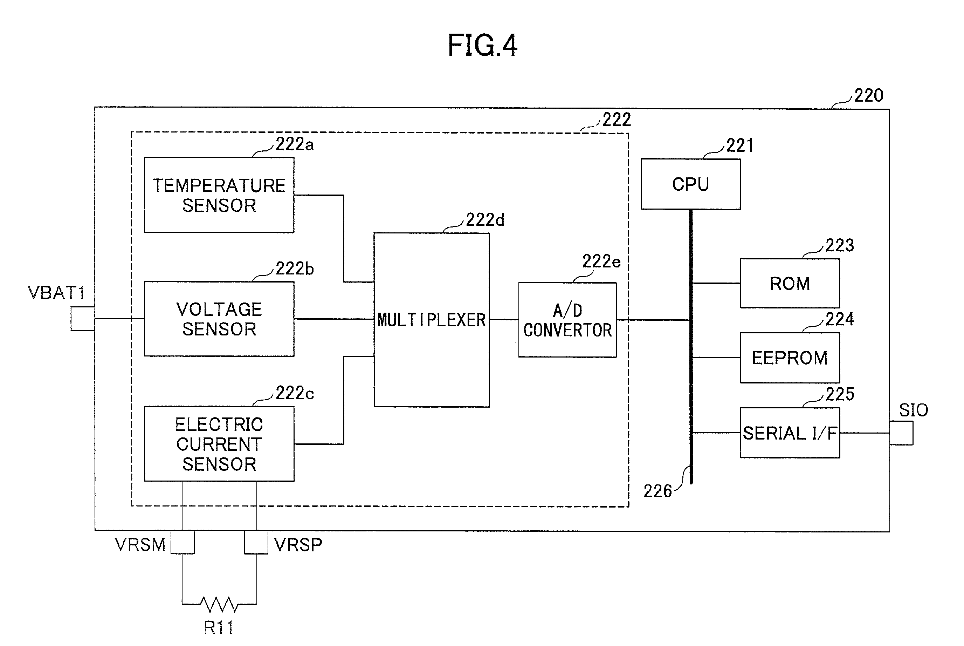

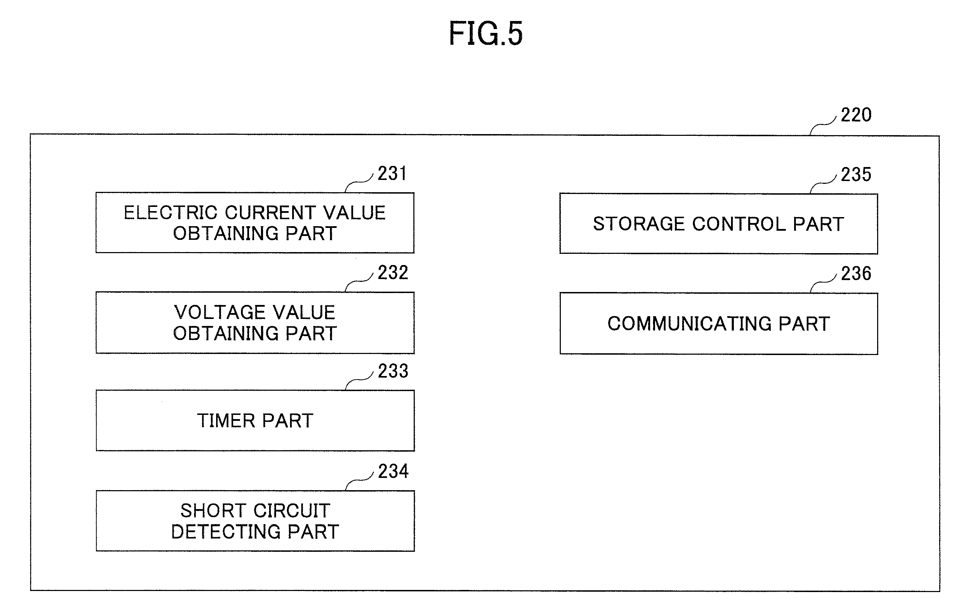

Next, details of the monitoring IC 220 are discussed with reference to FIG. 4 and Fig. 5. FIG. 4 is a view showing an example of a hardware structure of the monitoring IC 220. As shown in FIG. 4, the monitoring IC 220 includes a CPU (Central Processing Unit) 221, a sensor part 222, a ROM (Read Only Memory) 223, an EEPROM (Electrically Erasable and Programmable ROM) 224, and a serial interface (I/F) 225.

The CPU 221 is configured to control each of the parts of the monitoring IC 220. The sensor part 222 is configured to detect a voltage, an electric current, and a temperature of the battery unit 210. In the ROM 223, a program configured to be implemented so that the CPU 221 controls the parts of the monitoring IC 220 is stored. In the EEPROM 224, information is stored, such as parameters of the voltage, the electric current, and the temperature of the battery unit 210 detected by the sensor part 222. The serial I/F 225 is configured to communicate with the portable device 100 via the communication terminal SIO. The CPU 221, the sensor part 222, the ROM 223, the EEPROM 224, and the serial I/F 225 are connected to each other by a bus 226 so that data and a program can be exchanged among them.

In addition, the sensor part 222 includes a temperature sensor circuit 222a, a voltage sensor circuit 222b, an electric current sensor circuit 222c, a multiplexer 222d, and an analog-digital (A/D) converting circuit 222e.

The temperature sensor circuit 222a is configured to detect a temperature of the battery unit 210. The voltage sensor circuit 222b is configured to detect an output voltage of the battery unit 210 via the voltage detecting terminal VABT1 connected to the battery unit 210. The electric current circuit 222c is configured to detect an electric current flowing through the external resistor R11, namely a charge or discharge electric current of the battery unit 210, via the electric current detection terminals VRSP and VRSM. The outputs of the temperature sensor circuit 222a, the voltage sensor circuit 222b, and the electric current circuit 222c are connected to the multiplexer 222d and are output as a single signal by the multiplexer 222d. The A/D converting circuit 222e is configured to convert the signal output by the multiplexer 222d from analog to digital.

FIG. 5 is a view for explaining a functional structure of the monitoring IC 220. In this embodiment, the functional structure of the monitoring IC 220 illustrated in FIG. 5 is realized by a specific program stored in the ROM 223 illustrated in FIG. 4.

The monitoring IC includes an electric current value obtaining part 231, a voltage value obtaining part 232, a timer part 233, a short circuit detecting part 234, a storage control part 235, and a communicating part 236.

The electric current value obtaining part 231 is configured to obtain an electric current value detected by the electric current circuit 222c. The voltage value obtaining part 232 is configured to obtain a voltage value detected by the voltage sensor circuit 222b. The timer part 223 is configured to detect time by a timer function installed in the monitoring IC 220.

The short circuit detecting part 234 is configured to detect an internal short circuit in the battery unit 210 by the electric current value obtained by the electric current value obtaining part 231, the voltage value obtained by the voltage value obtaining part 232, and the timer function by the timer part 233. More specifically, in a case where the electric current value obtained by the electric current value obtaining part 231 is equal to or smaller than a designated value, the short circuit detecting part 234 stores the voltage value obtained by the voltage value obtaining part 232 by the storage control part 235. After a designated time passes in the state where the electric current value is equal to or smaller than the designated value, the voltage is obtained again by the voltage value obtaining part 232. In a case where a difference between the obtained voltage value and the stored voltage value is equal to or greater than a designated value, the internal short circuit is detected.

The storage control part 235 is configured to store a parameter (status information), such as the electric current value obtained by the electric current value obtaining part 231 or the voltage value obtained by the voltage value obtaining part 232, in, for example, the EEPROM 224 or the like. The communicating part 236 is configured to communicate with the portable device 100 where the battery pack 200 is installed.

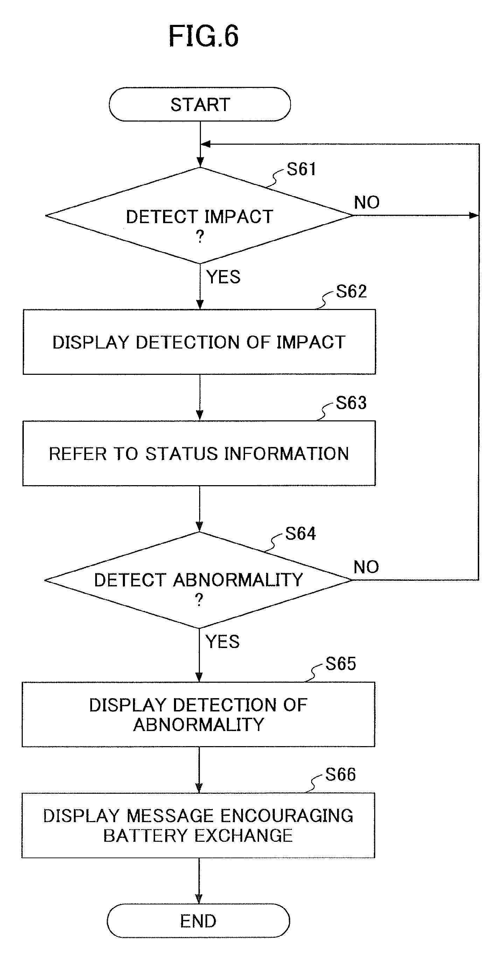

Next, operations of the portable device 100 of this embodiment are discussed. FIG. 6 is a flowchart for explaining the operations of the portable device 100 of this embodiment.

In the portable device 100, if impact applied to the portable device 100 is detected by the impact detecting part 110 in step S61, a process goes to step S62. The impact applied to the portable device 100 is, for example, impact at the time when the portable device 100 falls or impact when the portable device 100 hits an obstacle. In step S62, the display control part 140 makes the displaying device 12 display that the impact is detected.

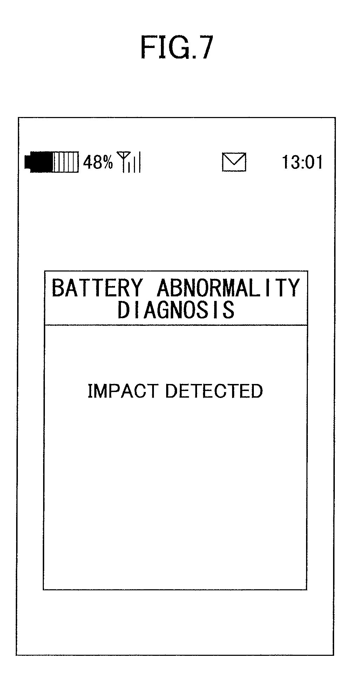

Examples of a screen displayed by the displaying device 12 of the portable device 100 are illustrated in FIG. 7 through FIG. 9. FIG. 7 is a view showing a first example of a screen displayed by the displaying device 12 of the portable device 100. In step S62, the display control part 140 makes the displaying device 12 display, as illustrated in FIG. 7, a message indicating that the impact is detected. In addition, the display control part 140 may make the displaying device 12 display that an abnormality determination, where whether the abnormality is generated in the battery unit 210 is determined, is started.

Referring back to FIG. 6, the process goes to step S63 after step S62 so that the status information referring part 120 in the portable device 100 refers to the status information of the battery pack 200. More specifically, the status information referring part 120 refers to the status information stored in the EEPROM 224 or the like of the monitoring IC 220 in the battery pack 200.

The process goes to step S64 after step S63. The abnormality determining part 130 determines whether abnormality is generated in the battery unit 210 based on the referred to status information. More specifically, the abnormality determining part 130 determines that the abnormality is generated in the battery unit 210 if the voltage value, the electric current value or the temperature of the battery unit 210 included in the referred to status information is out of the designated preset range.

In this embodiment, for example, items of the status information referred to by the status information referring part 120 may be preset. In this case, the abnormality determining part 130 determines whether the status information of the items are out of the designated range. More specifically, for example, if the status information referred to by the status information referring part 120 is set as the voltage value of the battery unit 210, the abnormality determining part 130 determines that the abnormality is generated in the battery unit 210 when the voltage value of the battery unit 210 is out of the designated range.

In this embodiment, for example, if all of the items of the status information referred to by the status information referring part 120 are out of the designated range, the abnormality determining part 130 may determine that the abnormality is generated in the battery unit 210. For example, in a case where the status information referred to by the status information referring part 120 is the voltage value, the electric current value and the temperature of the battery unit 210, the abnormality determining part 130 may determine that the abnormality is generated in the battery unit 210 when the voltage value, the electric current value and the temperature of the battery unit 210 are out of the designated ranges.

In the portable device 100 of this embodiment, information regarding a designated range is stored in, for example, the auxiliary storage device 14. The designated range here means a range of the voltage value, a range of the electric current value, or a range of the temperature whereby the status of the battery unit 210 is determined as normal.

The status information of this embodiment includes information indicating whether an internal short circuit of the battery unit 210 is detected. In the battery pack 200 of this embodiment, when the short circuit detecting part 234 detects the internal short circuit of the battery unit 210 by the monitoring IC 220, the storage control part 235 stores the information indicating the detection of the internal short circuit of the battery unit 210 in the EEPROM 224 or the like.

The abnormality determining part 130 determines that the abnormality is generated in the battery unit 210 even in a case where the information indicating the detection of the internal short circuit of the battery unit 210 is included in the status information referred to by the status information referring part 120.

If it is determined that the abnormality is detected in the battery unit 210 in step S64, the process goes to step S65. In step S65, the display control part 140 makes the displaying device 12 display that the abnormality is detected in the battery unit 210. The process goes to step S66 after step S65, so that the display control part 140 further makes the displaying device 12 display a screen encouraging the exchange of the battery pack 200.

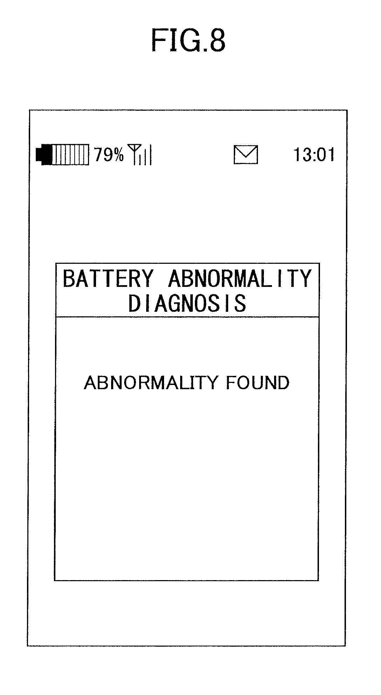

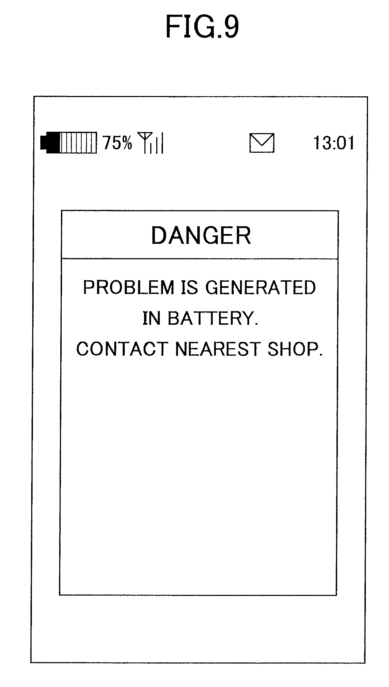

FIG. 8 is a view showing a second example of a screen displayed by the displaying device 12 of the portable device 100. An example of a screen indicating abnormality is detected at the battery unit 210 is illustrated in FIG. 8. The display control part 140 makes, as illustrated in FIG. 8, the displaying device 12 display a message where the abnormality is detected at the battery unit 210. FIG. 9 is a view showing a third example of a screen displayed by the displaying device 12 of the portable device 100. An example of a screen encouraging exchange of the battery pack 200 is illustrated in FIG. 9. The display control part 140 makes, as illustrated in FIG. 9, the displaying device 12 display a message encouraging exchange of the battery pack 200.

In this embodiment, as discussed above, when the impact is applied to the portable device 100, the abnormality of the battery unit 210 can be immediately detected and reported to the user or the like. Accordingly, according to the embodiment of the present invention, it is possible to prevent a state where the battery unit 210 having a problem is continuously used. Therefore, it is possible to prevent generation of an accident, due to continuous use of the battery having a problem, in advance. Hence, it is possible to improve safety in the use of the portable device 100.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority or inferiority of the invention. Although the embodiments of the present invention have been described in detail, it should be understood that the various changes, substitutions, and alterations could be made hereto without departing from the spirit and scope of the invention.

### INDUSTRIAL APPLICABILITY

The present invention is applicable to a portable device driven by a battery unit including a rechargeable battery which can be charged or discharged, a display method by the portable device, and a display program.

This International Patent Application is based upon and claims the benefit of priority of Japanese Patent Application No. 2008-184228 filed on July 15, 2008, the entire contents of which are incorporated herein by reference.

### EXPLANATION OF REFERENCE SIGNS

- 12: displaying device
- 100: portable device
- 110: impact detecting part
- 120: status information referring part
- 130: abnormality determining part
- 140: display control part
- 200: battery pack
- 210: battery unit
- 220: monitoring IC

## Claims

1. A portable device driven by a battery unit including a rechargeable battery which can be charged and discharged, the portable device comprising:
an impact detecting part configured to detect an impact applied to the portable device;
an abnormality determining part configured to determine whether an abnormality is generated in the battery unit based on status information indicating the status of the battery unit; and
a display control part configured to control displaying by a displaying device of the portable device,
wherein the abnormality determining part determines whether the abnormality is generated in the battery unit in a case where the impact is detected by the impact detecting part; and
the display control part performs the displaying indicating the abnormality of the battery unit in a case where the abnormality determining part determines that the battery unit is abnormal.

2. The portable device as claimed in claim 1, further comprising:
a monitoring part configured to monitor the status of the battery unit and obtain the status information of the battery unit,
wherein the abnormality determining part refers to the status information obtained by the monitoring part so as to determine whether the abnormality is generated in the battery unit.

3. The portable device as claimed in claim 2, wherein the monitoring part includes:
an electric current detecting part configured to detect an electric current flowing in the battery unit;
a voltage detecting part configured to detect a voltage of the battery unit;
a temperature detecting part configured to detect a temperature of the battery unit; and
an internal short circuit detecting part configured to detect an internal short circuit of the battery unit.

4. The portable device as claimed in claim 3,
wherein the battery unit and the monitoring part are included in a battery pack provided in the portable device.

5. A display method of a portable device, the portable device being driven by a battery unit including a rechargeable battery which can be charged and discharged, the display method comprising:
an impact detecting step of detecting an impact applied to the portable device;
an abnormality determining step of determining whether an abnormality is generated in the battery unit based on status information indicating the status of the battery unit; and
a display control step of controlling displaying by a displaying device of the portable device,
wherein, in the abnormality determining step, whether the abnormality is generated in the battery unit is determined in a case where the impact is detected in the impact detecting step; and
the displaying indicating the abnormality of the battery unit is performed in the display control step in a case where it is determined that the battery unit is abnormal in the abnormality determining step.

6. A display program performed in a portable device, the portable device being driven by a battery unit including a rechargeable battery which can be charged and discharged, the program making the portable device execute a method, the method comprising:
an impact detecting step of detecting an impact applied to the portable device;
an abnormality determining step of determining whether an abnormality is generated in the battery unit based on status information indicating the status of the battery unit; and
a display control step of controlling displaying by a displaying device of the portable device,
wherein, in the abnormality determining step, whether the abnormality is generated in the battery unit is determined in a case where the impact is detected in the impact detecting step; and
the displaying indicating the abnormality of the battery unit is performed in the display control step in a case where it is determined that the battery unit is abnormal in the abnormality determining step.
